# EUROPÄISCHE PATENTSCHRIFT

(11) **EP 4 211 480 B1**
(45) Veröffentlichungstag und Bekanntmachung des Hinweises auf die Patenterteilung: **07.01.2026**
(21) Anmeldenummer: 20815725.5
(22) Anmeldetag: 06.11.2020
(51) Int. Cl.: G01R 31/62, G01R 31/72

(54) **ÜBERWACHUNG DES BETRIEBS EINER ELEKTRISCHEN SPULEN-ANORDNUNG**
MONITORING THE OPERATION OF AN ELECTRICAL COIL ASSEMBLY
SURVEILLANCE DU FONCTIONNEMENT D'UN ENSEMBLE DE BOBINES ÉLECTRIQUES

(43) Veröffentlichungstag der Anmeldung: 19.07.2023
(73) Patentinhaber: Siemens Energy Global GmbH & Co. KG, 81739 München (DE)
(72) Erfinder: ARMSCHAT, Christoph, 91058 Erlangen (DE); REISINGER, Helmut, 4222 St. Georgen/Gusen (AT); POINTNER, Klaus, 4040 Linz (AT)
(86) Internationale Anmeldenummer: PCT/EP2020/081289
(87) Internationale Veröffentlichungsnummer: WO 2022/096121

(56) Entgegenhaltungen:
- WO-A1-2019/219196
- CN-A- 110 581 532
- CN-A- 111 679 163

## Beschreibung

Die vorliegende Erfindung betrifft ein Verfahren zur Überwachung des Betriebs einer elektrischen Anordnung, insbesondere einer Drossel-Anordnung, welche eine Mehrzahl an elektrisch in einer Parallelschaltung angeordnete Spulen bzw. Spulenwicklungen aufweist. Die Erfindung betrifft weiterhin eine elektrische Anordnung, insbesondere eine Drossel-Anordnung, und ein Verfahren zum Betreiben einer solchen Anordnung.

Elektrisch in Parallelschaltung angeordnete Spulen werden zum Beispiel im Zusammenhang mit Transformatoren oder elektrischen Drosseln, zum Beispiel Luftdrosseln oder ölisolierten Drosseln oder gasisolierten Drosseln verwendet. In derartigen Spulen können in seltenen Fällen Windungskurzschlüsse auftreten. Um weitere Schäden, insbesondere einen dadurch ausgelösten Brand, beispielsweise einen Drosselbrand, zu verhindern, ist es von Vorteil, wenn ein Windungskurzschluss möglichst schnell und zuverlässig diagnostiziert werden kann.

In dem Dokument WO 2019/219196 A1 sind ein Verfahren und eine Vorrichtung zur Erkennung eines Windungskurzschlusses bei in Parallelschaltung angeordneten Spulen beschrieben. Dabei wird für die Spulen der Parallelschaltung jeweils der Stromunterschied zwischen dem durch die einzelnen Spulen fließenden Strom und dem Mittelwert der durch die Spulen fließenden Ströme ermittelt. Anhand der Stromunterschiede wird erkannt, wenn bei einer der Spulen ein Windungskurzschluss auftritt.

Neben der Erfassung von geeigneten Signalen, welche einen Windungskurzschluss zuverlässig anzeigen, stellt die zuverlässige Übermittlung der Signale an entsprechende Überwachungseinheiten eine Herausforderung dar. Die schnurlose Übermittlung von Signalen ist in der Regel einfach und kostengünstig, aber auch weniger zuverlässig als eine fest verdrahtete Signalübertragung. Bisher werden schutzrelevante Daten oder Ereignisse oder Signale fast ausschließlich drahtgebunden oder per Lichtwellenleiter übertragen. Auf Hochspannungspotenzial ist diese Verdrahtung bzw. Verlegung von Lichtwellenleitern jedoch kostenaufwendig. Funksensoren, welche zur Signalübertragung verwendet werden, sind störanfällig und können insbesondere dann ausfallen, wenn sie batteriegespeist sind. Die lange Kette von Signalerfassung, Digitalisierung in Funksensorknoten, Aufbereitung und das Übertragen mittels Funkmodul enthält viele potenzielle Fehlerquellen, so dass Funktechnik alleine für schutzrelevante Funktionen nicht zulässig ist. Akustische Signale können durch Hintergrund-Geräuschpegel gestört werden. Optische Signale können durch Streulicht oder Verschattung beim Empfänger gestört werden. Dennoch ist die schnurlose Übertragung von Signalen attraktiv, allerdings findet eine Verknüpfung von redundanten Übertragungswegen bisher praktisch nicht statt.

Ein Drosselbrand wird typischerweise durch einen Kurzschluss einer Windung, in der Regel in der Folge eines Isolationsfehlers, ausgelöst. In einer Drossel, die in der Regel mehrere konzentrische Lagen von parallel geschalteten Wicklungslagen aufweist, entsteht durch einen Isolationsfehler eine Kurzschlusswindung. Die Windung heizt sich sehr schnell auf wegen des hohen, aus dem Magnetfeld der Drossel induzierten Stroms. Die Isolation der Windung kann, je nach Materialzusammensetzung zu brennen anfangen. Liegt nun die Kurzschlusswindung im Inneren des Drosselkörpers, ist eine Erkennung mittels ultraviolettem Licht (UV-Licht) durch eine Brandmeldeanlage nicht wirksam. Bedingt durch die langsame Reaktion der Anlage über die entstehenden Rauchgase kann der gesamte Drosselkörper zwischenzeitlich so stark erhitzt sein, dass der Brand nicht von selbst verlöscht. Insbesondere bei Drosseln, die in Hallen aufgestellt sind, kann durch eine starke Verschmutzung der Halle eine UV-Erkennung schwierig sein. Weiterhin besteht die Gefahr, dass der Brand auf benachbarte Geräte übergreift.

Es ist daher wünschenswert, eine sichere Früherkennung einer fehlerhaften Kurzschlusswindung zu gewährleisten. Zusätzliche optische Überwachungssysteme, insbesondere mit Lichtwellenleiter-Übertragung und eigenen Auswertungseinheiten, sind vergleichsweise kostenintensiv.

Es ist daher eine Aufgabe der vorliegenden Erfindung, eine einfache, sichere und kosteneffiziente Möglichkeit zur Überwachung des Betriebs einer elektrischen Anordnung, welche eine Mehrzahl an elektrisch in einer Parallelschaltung angeordneten Spulen aufweist, zur Verfügung zu stellen. Weitere Aufgaben bestehen darin, eine vorteilhafte elektrische Anordnung und ein Verfahren zum Betreiben dieser zur Verfügung zu stellen.

Die erste Aufgabe wird durch ein Verfahren zur Überwachung des Betriebs einer elektrischen Anordnung, beispielsweise einer Drosselanordnung oder einer Transformatoranordnung, welche eine Mehrzahl an elektrisch in einer Parallelschaltung angeordnete Spulen bzw. Spulenwicklungen aufweist, gemäß Patentanspruch 1 gelöst. Die weiteren Aufgaben werden durch eine elektrische Anordnung, welche eine Mehrzahl an elektrisch in einer Parallelschaltung angeordnete Spulen bzw. Spulenwicklungen aufweist, gemäß Patentanspruch 11 und durch ein Verfahren zum Betreiben einer solchen Anordnung gemäß Patentanspruch 17 gelöst. Die abhängigen Ansprüche enthalten weitere vorteilhafte Ausgestaltungen der Erfindung.

Im Folgenden werden unter dem Begriff Spulen sowohl räumlich parallel nebeneinander als auch konzentrisch umeinander angeordnete Spulenwicklungen verstanden.

Das erfindungsgemäße Verfahren zur Überwachung des Betriebs einer elektrischen Anordnung betrifft eine Anordnung, welche eine Mehrzahl an elektrisch in einer Parallelschaltung angeordnete Spulen aufweist. Bei der Anordnung kann es sich beispielsweise um eine Drossel oder einen Transformator handeln. Die Anordnung kann zum Beispiel mindestens 2 oder mindestens 3 elektrisch in einer Parallelschaltung angeordnete Spulen aufweisen. Beim bestimmungsgemäßen Betrieb der Anordnung werden die Spulen von elektrischem Strom durchflossen.

Das erfindungsgemäße Verfahren umfasst folgende Schritte: Mittels einer an einer Windung angeordneten Anzapfung oder einem Abgriff wird die an jeder Spule anliegende Spannung leistungsfrei erfasst, zum Beispiel gemessen. Der in der jeweils erfassten Spannung enthaltende Wechselspannungsanteil (AC-Anteil) wird für jede Spule bestimmt. Es wird der Mittelwert der an den Spulen anliegenden Spannung bestimmt. Der in der erfassten Spannung enthaltende AC-Anteil wird für jede Spule in Bezug auf den bestimmten Mittelwert der Spannung ausgewertet. Dabei wird eine Gewichtung vorgenommen. Anschließend wird ein Signal ausgegeben, falls eine gewichtete Abweichung eines Wertes, der den in der gemessenen Spannung enthaltenden AC-Anteil einer Spule beschreibt, von einem Wert, der den Mittelwert der Spannung beschreibt, einen festgelegten Grenzwert überschreitet.

Vorzugsweise wird im Rahmen des Verfahrens der Betriebsstrom der Anordnung erfasst und die Gewichtung mittels des erfassten Betriebsstroms vorgenommen. Alternativ dazu können die Abweichungen der einzelnen Spulenspannungen ins Verhältnis zum Absolutwert der aktuell am Abgriff gemessenen Spannung, beispielsweise zu dem Mittelwert der an den Abgriffen gemessenen Spannungen, gesetzt werden. Auch so ist das Rauschen bei kleinen Spannungen bzw. Strömen eliminierbar. Eine zusätzliche Strommessung erübrigt sich so oder ist optional.

Als Wert, der den in der gemessenen Spannung enthaltenden AC-Anteil einer Spule beschreibt, kann zum Beispiel der Effektivwert und/oder den Amplitudenwert und/oder der Spitze-Spitze-Wert des AC-Anteils und/oder die zeitliche Änderung, also das Differenzial, der Abweichung der erfassten Spannung von dem Mittelwert ermittelt werden. Als ein Wert, der den Mittelwert der Spannung beschreibt, kann der Mittelwert des Gleichspannungsanteils (DC-Anteil) der Spannung und/oder der Mittelwert der Effektivwerte der AC-Anteile der Spannung der einzelnen Spulen und/oder der Mittelwert der Amplitudenwerte und/oder der Mittelwert der Spitze-Spitze-Werte und/oder die zeitliche Änderung, also das Differenzial, des Mittelwertes der Spannung ermittelt werden. Die Berücksichtigung der genannten Differenziale im Rahmen der Auswertung hat den Vorteil, dass so die Genauigkeit der Überwachung erhöht wird und eine sehr schnelle Erkennung eines Windungskurzschlusses bereits vor dem Auftreten von damit verbundenen hohen Stromstärken möglich ist.

Bei den Spulen kann es sich zum Beispiel um trockenisolierte Luftkern-Spulen oder um flüssigkeitsisolierte Spulen mit Eisenkern oder um gasisolierte Spulen oder eine Kombination aus einzelnen dieser Varianten handeln.

Das erfindungsgemäße Verfahren hat den Vorteil, dass es ein Erkennen eines Windungskurzschlusses ermöglicht, bevor eine Erkennung eines Brandes mit herkömmlichen UV-Licht-Sensoren oder Infrarotsensoren oder über eine Rauchgaserkennung möglich ist. Damit ist eine frühzeitige Detektion möglich, wodurch weitere Schäden an der Anordnung und gegebenenfalls an weiteren Bauteilen vermieden werden. Weiterhin ist es möglich, den Windungskurzschluss einer konkreten Spule zuzuordnen. Diese kann gezielt ersetzt und/oder repariert werden, ohne dass weitere Diagnoseschritte zur Identifizierung der betroffenen Spule erforderlich sind. Auf diese Weise werden Zeit und Kosten eingespart. Insgesamt ermöglicht die vorliegende Erfindung eine kostengünstige und effiziente Fehlererkennung.

In einer vorteilhaften Variante weist jede der Spulen ein Hauptanschluss-Terminal auf. Vorzugsweise erfolgt das leistungsfreie Erfassen, beispielsweise Messen, der an jeder Spule anliegenden Spannung zwischen dem Hauptanschluss-Terminal und der Anzapfung. Vorzugsweise ist die Anzapfung an einer ersten Windung ausgehend von dem Hauptanschluss-Terminal angeordnet. Dabei ist die Anzapfung vorzugsweise in einem Abstand von weniger als einer Windungslänge ausgehend von dem Hauptanschluss-Terminal angeordnet. Die Anzapfung kann zum Beispiel in einem Abstand von maximal zwei Dritteln der Leiterlänge der ersten Windung, insbesondere bei Luftdrosseln, ausgehend von dem Hauptanschluss-Terminal angeordnet sein. Vorzugsweise ist die Anzapfung bei etwa einer halben Windungslänge, also in einem Abstand von einer halben Windungslänge ausgehend von dem Hauptanschluss-Terminal, angeordnet. Da die Spannung je Windung einer Drossel oder eines Reaktors beim ölisolierten Transformator üblicherweise bei 800V liegt, ermöglicht diese Ausgestaltung bei der Nutzung eines (kleineren) Teils der ersten Windung eine mittels Signal-Spannungsteiler in der Elektronik noch gut handhabbare Spannung.

Die Anzapfung ist über ein Anschluss-Terminal mit einer ersten Windung der Spule, gesehen von dem Hauptanschluss-Terminal, elektrisch leitend verbunden. Ein entsprechendes Anschluss-Terminal hat den Vorteil, dass die Anzapfung flexibel angeschlossen oder entfernt werden kann. Dies ist beispielsweise im Fall eines Auswechselns einer Spule oder eines Wechsels der Anzapfung von Vorteil, da hierdurch eine schnelle und einfache Handhabung ermöglicht wird.

In einer weiteren Variante kann die Anordnung einen Tragstern umfassen, an welchem die Spulen befestigt sind. Die Anzapfungen sind in dieser Variante bevorzugt so ausgestaltet, dass die isolierten Signaldrähte aus den Anzapfungen der Spulen in Richtung des Tragsterns geführt sind, also auf möglichst kurzem Weg zum Tragstern isoliert geführt sind, wo sie mit einer Mess-Elektronik verbunden werden. Dies ist aus Sicherheitsaspekten von Vorteil, da die entstehende Spannung bei dieser Ausgestaltung auch in transienten Fällen gut beherrschbar ist. Als Nennspannung im Wechselanteil können zum Beispiel 20 Volt Wechselspannung angezapft werden, sodass im Falle einer einlaufenden transienten Überspannung die Signalspannung von zum Beispiel Spannungsspitzen zwischen 50 Volt und einigen Kilovolt mit kleinen Überspannungsableitern begrenzt werden können.

In einer weiteren Variante wird der Wechselstromanteil (AC-Anteil) des Betriebsstroms erfasst. Unter dem Betriebsstrom wird der Gesamtstrom, der durch die Mehrzahl der Spulen schließt, verstanden. Der erfasste AC-Anteil des Betriebsstroms kann zur Gewichtung verwendet werden. Zusätzlich oder alternativ dazu kann das Verhältnis der Abweichung des Wertes, der den in der gemessenen Spannung enthaltenden AC-Anteil einer Spule beschreibt, von dem Wert, der den Mittelwert der Spannung beschreibt, zu dem AC-Anteil des Betriebsstroms ermittelt werden. Falls das Verhältnis einen festgelegten Grenzwert überschreitet, kann ein Signal ausgegeben werden. Durch die beschriebene Berücksichtigung des AC-Anteils des Betriebsstroms wird die Genauigkeit der Auswertung für kleine Betriebsströme verbessert und gleichzeitig bei hohen Betriebsströmen zur Vermeidung von fehlerhaften Einschätzungen eine gröbere Auswertung mit einer höheren Toleranz ermöglicht.

In einer weiteren Variante kann das Magnetfeld der einzelnen Spulen, insbesondere bei räumlich getrennt aufgebauten Einzelspulen, gemessen werden und das Verhältnis des Magnetfeldes zu dem Betriebsstrom und/oder zu dem AC-Anteil des Betriebsstroms ermittelt werden. Falls das Verhältnis für eine Spule einen festgelegten, beispielsweise in Abhängigkeit von dem Betriebsstrom gewichteten, Schwellenwert erreicht, kann ein Signal ausgegeben werden. Damit wird eine Änderung des Magnetfeldes einzelner Spulen als Indikator für das Vorliegen eines Windungskurzschlusses hinzugezogen und damit die Auswertung präzisiert.

Weiterhin können das den AC-Anteil der Spannung beschreibende Signal und/oder ein den AC-Anteil des erfassten Betriebsstroms beschreibendes Signal gleichgerichtet werden und/oder geglättet werden. Die Glättung kann zum Beispiel mit einer festgelegten Zeitkonstante erfolgen, beispielsweise einer Zeitkonstante von 300 Millisekunden. Auf diese Weise wird die Aussagekräftigkeit des Signals verbessert. Transiente, d.h. zeitlich stark begrenzte, Abweichungen führen im Falle einer Gleichrichtung und Glättung nicht zu einem fehlerhaften, weitere Maßnahmen auslösenden Signal.

Vorzugsweise wird das im Rahmen des erfindungsgemäßen Verfahrens ausgegebene Signal über eine Mehrzahl redundanter Signalübertragungswege an eine Überwachungseinrichtung übertragen. Dies kann mittels eines Lichtwellenleiters und/oder durch akustische Übertragung und/oder durch UV-Lichtübertragung und/oder durch Funkwellenübertragung erfolgen. Auf diese Weise ist es möglich, eine Mehrzahl redundanter Signalübertragungswege zu generieren und eine zuverlässige und belastbare Signalübertragung zu gewährleisten.

In einer weiteren Variante kann mittels einer Induktionsspule, beispielsweise eine Luftkern-Spule, aus einem Wechselfeld der Spulen Energie gewonnen werden. Diese Energie kann zur Auswertung und/oder Generierung von Signalen und/oder zur Übertragung von Signalen verwendet werden. Diese Ausgestaltung hat den Vorteil, dass ein potenziell fehleranfälliger Batteriebetrieb des Überwachungsverfahrens vermieden werden kann. Weiterhin trägt diese Ausgestaltung zu einer Verbesserung der Kosteneffizienz des Verfahrens und der Anordnung, so wie eine Reduzierung der Fehleranfälligkeit bei. Zusätzlich werden die Komplexität und die mit einer Nachrüstung verbundene Kosten für eine entsprechende Überwachung reduziert. Die Querschnittsfläche der Induktionsspule kann einen Durchmesser zwischen 10 cm und 20 cm, z.B. 15 cm, aufweisen. Alternativ kann die Energie mittels eines sättigbaren Stromwandlers, gegebenenfalls mit einer DC-Vormagnetisierung im Eisenkern, gewonnen werden.

Die erfindungsgemäße elektrische Anordnung, bei welcher es sich zum Beispiel um eine Drossel-Anordnung oder eine Transformator-Anordnung handeln kann, weist eine Mehrzahl an elektrisch in einer Parallelschaltung angeordnete Spulen auf. Im Rahmen des bestimmungsgemäßen Betriebs der Anordnung sind die Spulen von einem elektrischen Strom durchflossen. Jede Spule weist eine Anzapfung an einer Windung auf. Die elektrische Anordnung umfasst eine Einrichtung zum leistungsfreien Erfassen, z.B. Messen, der an jeder Spule anliegenden Spannung mittels der Anzapfung und eine Auswertungseinrichtung. Die erfindungsgemäße elektrische Anordnung ist zur Ausführung eines zuvor beschriebenen erfindungsgemäßen Verfahrens ausgelegt. Die erfindungsgemäße Anordnung hat die oben bereits im Zusammenhang mit dem erfindungsgemäßen Verfahren genannten Merkmale und Vorteile. Optional kann die Anordnung eine Einrichtung zum Erfassen des Betriebsstroms der Anordnung umfassen.

Die Auswertungseinrichtung kann zum Beispiel zum Erfassen des in der jeweils gemessenen Spannung enthaltenden AC-Anteils für jede Spule und/oder zum Bestimmen des Mittelwertes der an den Spulen anliegenden Spannung und/oder zum Auswerten des in der gemessenen Spannung enthaltenden AC-Anteils für jede Spule in Bezug auf den bestimmten Mittelwert des Spannung ausgelegt sein. Die Auswertungseinrichtung kann weiterhin dazu ausgelegt sein, im Rahmen der Auswertung eine Gewichtung vorzunehmen, zum Beispiel mittels des erfassten Betriebsstroms oder der Spannungen. Sie kann weiterhin zum Ausgeben eines Signals ausgelegt sein, falls eine gewichtete Abweichung eines Wertes, der den in der gemessenen Spannung enthaltenden AC-Anteile einer Spule beschreibt, von einem Wert, der den Mittelwert der Spannung beschreibt, einen festgelegten Grenzwert überschreitet.

Die erfindungsgemäße Anordnung kann mindestens 2 oder mindestens 3 Spulen umfassen. Bei den Spulen kann es sich zum Beispiel um Luftkern-Spulen oder ölisolierte Spulen oder gasisolierte Spulen handeln. Die Spulen können räumlich sowohl parallel nebeneinander als auch konzentrisch umeinander angeordnet sein (Aufbau einer Drossel aus verschiedenen Lagen). Das heißt auch eine einzelne, als physikalisch und elektrisch als Einheit dastehende einphasige Drossel (insbesondere Luftdrossel) mit nur zwei elektrischen Anschlusspunkten kann aufgrund der Messungen in ihren einzelnen konzentrischen und parallel geschalteten Lagen mit dem hier beschriebenen Konzept überwacht werden. Die Anordnung kann mindestens eine Induktionsspule zur Energiegewinnung aufweisen.

Vorzugsweise weist jede der Spulen ein Hauptanschluss-Terminal auf und die Anzapfung ist an einer ersten Windung, ausgehend von dem Hauptanschluss-Terminal der Spule angeordnet. Die Einrichtung zum leistungsfreien Erfassen der an jeder Spule anliegenden Spannung ist vorzugsweise zum Erfassen der Spannung zwischen dem Hauptanschluss-Terminal und der Anzapfung ausgelegt. Die Anzapfung kann ein Anschluss-Terminal aufweisen. Das Anschluss-Terminal kann mit der anzuzapfenden Windung der Spule verbunden sein. Vorteilhafter Weise ist die Anzapfung in einem Abstand von maximal zwei Dritteln der Leiterlänge der ersten Windung, ausgehend von dem Hauptanschluss-Terminal angeordnet, zum Beispiel in einem Abstand von etwa einer halben Leiterlänge der ersten Windung.

Die Anordnung kann einen Tragstern umfassen, an welchem die Spulen befestigt sind. Die Anzapfungen können so ausgestaltet sein, dass sie aus den Spulen in Richtung des Tragsterns geführt sind. Die diesbezüglichen Vorteile und weiteren Ausgestaltungsmerkmalen sind oben bereits im Zusammenhang mit dem erfindungsgemäßen Verfahren beschrieben worden.

Die Anordnung kann weiterhin mindestens eine Signal-Bedämpfungs-Drossel und/oder mindestens einen Überspannungsableiter aufweisen. Der Überspannungsableiter kann der Signal-Bedämpfungs-Drossel nachgeschaltet sein. Weiterhin können Einrichtungen zum Gleichrichten und/oder Glätten von AC-Signalen vorgesehen sein.

Das erfindungsgemäße Verfahren zum Betreiben einer zuvor beschriebenen Anordnung zeichnet sich dadurch aus, dass die Anordnung bestimmungsgemäß betrieben wird, wobei ein oben beschriebenes erfindungsgemäßes Verfahren zur Überwachung des Betriebs der Anordnung durchgeführt wird. Der Betrieb der Anordnung wird unterbrochen, beispielsweise wird die Anordnung abgeschaltet, falls im Rahmen des Verfahrens zur Überwachung mindestens ein Signal an eine Überwachungseinrichtung ausgegeben wird, welches auf mindestens zwei redundanten Übertragungswegen von einer Überwachungseinrichtung empfangen wurde. Auf diese Weise ist eine zuverlässige und kostengünstige Fehlererkennung, insbesondere eine Erkennung von Windungskurzschlüssen, möglich.

Im Rahmen der vorliegenden Erfindung werden die Signale der einzelnen Spulen bzw. einzelnen Lagen verglichen. Weicht eine Spulen- oder Lagenspannung plötzlich von der mittleren Lagenspannung ab, so ist dies ein Indikator für einen Lagenkurzschluss. Die Abweichung wird vorzugsweise gewichtet durch den Gesamtstrom bzw. Betriebsstrom der Anordnung, beispielsweise der Drossel. Wenn der Gesamtstrom groß ist, muss die Lagenspannungsabweichung größer sein, als bei kleinem Betriebsstrom, um einen Windungskurzschluss sicher zu identifizieren. In einer elektronischen Beschaltung wird aus der Differenzspannung ein über die Betriebsstrommessung gewichtetes Triggersignal gebildet, welches dann eine vorteilhafterweise redundante, drahtlose Signalübertragungskette zum Schutz bzw. einer Überwachungsvorrichtung hin ansteuert. Bei einer Auswertung der Differenziale kann eine preisgünstige, weniger genauere Messtechnik zum Einsatz kommen. Dazu wird ein Differenzialvergleich der gemessenen Spannungen gemacht, ähnlich einer H-Schaltung einer Wheatstone-Brücke.

Prinzipiell kann zwischen parallel stehenden Drosseln und einer einzelnen Drossel mit mehreren Lagen unterschieden werden. Je nach Ausprägung der Fehlerstelle in der kurzgeschlossenen Windung verändern sich die einzelnen Lagenströme und somit auch die Lagenspannungen an den Anzapfungen bei Fehlereintritt unterschiedlich oder in ähnlichem Maße. Eine niederohmige Kurzschluss-Fehlerstelle ist einfach zu detektieren, da sich nur der Strom bzw. die Spannung in der fehlerhaften Lage ändert und die Erkennung des Fehlers kann sofort zur Abschaltung verwendet werden. Die hochohmige Fehlerstelle führt zu einem geringeren Ansteigen in den Lagenströmen. Auch die Ströme in den benachbarten, fehlerfreien Lagen der Anordnung steigen an. Ein Vergleich der Lagenströme und/oder Lagenspannungen untereinander kann in diesem Fall möglicherweise nicht als hinreichendes Kriterium für eine Abschaltung verwendet werden. In diesem Fall kann der Lagenstrom mit einer externen Strommessung im gleichen Strompfad der Anordnung verglichen werden und/oder kann der Strom von Spulen der benachbarten Phasen zur Bewertung des Fehlers herangezogen werden und/oder das für hochohmige Fehlerstellen typische An- und Ausgehen des Lichtbogens in der Fehlerstelle durch einen intelligenten Sensorknoten erkannt werden. Dies äußert sich zum Beispiel in Flackern bzw. Sprüngen im Verhältnis der Lagenströme in den hochohmigen Windungskurzschluss oder Windungsfehler, der sich im Laufe der Zeit in einem niederohmigen Fehler weiterentwickeln kann. Die Signalsprünge können für eine Warnmeldung verwendet werden, die weitere Verknüpfungen von Informationen initiieren kann. Solche Verknüpfungen können auch das Ansprechen vereinzelter Brandmelder oder schwache akustische Indikationen sein, die mittels Mikrofon detektiert werden. Die Summe der Indikatoren kann dann zum hinreichenden Kriterium für eine Abschaltung verwendet werden.

Als Signalwege zu einer Überwachungseinrichtung, beispielsweise zur Schutzauslösung, können folgende Möglichkeiten verwendet werden: In einer ersten Variante kann UV-Licht von einer UV-Lichtquelle erzeugt und gerichtet zu Sensoren einer Brandschutzanlage abgestrahlt werden. Alternativ oder zusätzlich kann das Licht über Lichtwellenleiter zu einem Auswertegerät auf Erdpotenzial gesendet werden. In einer zweiten Variante kann ein akustisches Warnsignal von einem Lautsprecher aus gesendet werden. In einer dritten Variante kann ein Funksignal abgesetzt werden. Bei Vorliegen von zwei der drei genannten Signalübertragungen kann die Abschaltung der Gesamtanlage ausgelöst werden. Die Spulen, beispielsweise Drosseln, können dann sorgfältig in Bezug auf ihre Induktivität und Isolation geprüft und gegebenenfalls gewartet werden.

Die vorliegende Erfindung ermöglicht eine sehr präzise und verzögerungsfreie Erkennung von hohen Strömen in einer Kurzschlusswindung einer Spule, beispielsweise einer luftisolierten Drossel, die von Wechselstrom oder von Wechsel- und Gleich-Strömen gemischt durchflossen wird. Es ist prinzipiell keine Verlegung von zusätzlichen Drähten oder Lichtwellenleiter erforderlich, was eine Kosteneinsparung bedeutet. Für eine fehlerfreie Erkennung eines unzulässigen Betriebszustandes ist es zweckmäßig, über verschiedenartige oder unabhängige Fehlererkennungstechniken zu verfügen. Die vorliegende Erfindung liefert eine weitere Erkennungstechnik hierfür. Eine redundante Signalübertragung ermöglicht eine sichere Übertragung des Signals. Leistungsfähige, bereits existierende UV-Überwachungen in Hallen mit entsprechenden Anlagen können nicht nur zur Branderkennung genutzt werden, sondern auch für eine Früherkennung von hohen Strömen in einer fehlerhaften Windung einer Spule, beispielsweise einer Drossel. Die Installation von einer akustischen Signalerkennung in einer Drosselhalle ermöglicht auch die Erkennung von Teilentladungen, von Teilüberschlägen und von sich entwickelnden mechanischen Defekten im Drosselkörper. Bei teilweise metallisch verbauten Sichtlinien, beispielsweise in Konverterräumen, ermöglicht eine akustische Signalübertragung aufgrund der guten Beugung und Reflektion akustischer Wellen eine zuverlässige Signalübertragung. Eine Mehrfachnutzung der akustischen Empfangssignale ist auf diese Weise möglich, beispielsweise für verschiedene Geber oder Fehlerarten durch verschiedenartige akustische Fehlermeldungen. Dies kann zum Beispiel auf verschiedenen Frequenzen oder mit Modulation des Signals realisiert werden. Weiterhin kann die Energie des Messsignals zur Speisung der Übertragungstechnik genutzt und gegebenenfalls gespeichert werden, womit eine Batteriespeisung überflüssig wird.

Die Erfindung wird im Folgenden anhand von Ausführungsbeispielen unter Bezugnahme auf die beigefügten Figuren näher erläutert. Obwohl die Erfindung im Detail durch die bevorzugten Ausführungsbeispiele näher illustriert und beschrieben wird, so ist die Erfindung nicht durch die offenbarten Beispiele eingeschränkt und andere Variationen können vom Fachmann hieraus abgeleitet werden, ohne den Schutzumfang der Erfindung zu verlassen.

Die Figuren sind nicht notwendigerweise detailgetreu und maßstabsgetreu und können vergrößert oder verkleinert dargestellt sein, um einen besseren Überblick zu bieten. Daher sind hier offenbarte funktionale Einzelheiten nicht einschränkend zu verstehen, sondern lediglich als anschauliche Grundlage, die dem Fachmann auf diesem Gebiet der Technik Anleitung bietet, um die vorliegende Erfindung auf vielfältige Weise einzusetzen.

Der hier verwendete Ausdruck "und/oder", wenn er in einer Reihe von zwei oder mehreren Elementen benutzt wird, bedeutet, dass jedes der aufgeführten Elemente alleine verwendet werden kann, oder es kann jede Kombination von zwei oder mehr der aufgeführten Elemente verwendet werden. Wird beispielsweise eine Zusammensetzung beschrieben, dass die Komponenten A, B und/oder C, enthält, kann die Zusammensetzung A alleine; B alleine; C alleine; A und B in Kombination; A und C in Kombination; B und C in Kombination; oder A, B, und C in Kombination enthalten.
- Fig. 1: zeigt schematisch ein erfindungsgemäßes Verfahren zur Überwachung des Betriebs einer elektrischen Anordnung in Form eines Flussdiagramms.
- Fig. 2: zeigt schematisch ein erfindungsgemäßes Verfahren zum Betreiben einer elektrischen Anordnung, welche eine Mehrzahl, elektrisch in einer Parallelschaltung angeordnete Spulen aufweist, in Form eines Flussdiagramms.
- Fig. 3: zeigt schematisch eine erfindungsgemäße elektrische Anordnung in einer perspektivischen Ansicht.
- Fig. 4: zeigt schematisch einen Querschnitt durch ein Leiterbündel einer Spule.
- Fig. 5: zeigt schematisch eine erfindungsgemäße Anordnung und das Prinzip der vorliegenden Erfindung in Form eines Blockdiagramms.

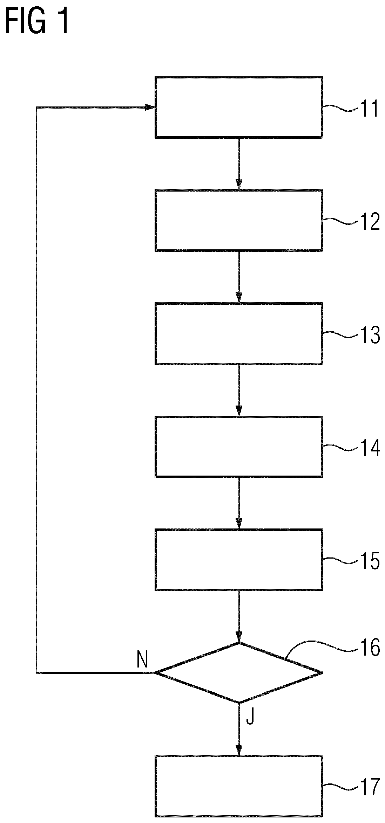

Die Figur 1 zeigt schematisch ein erfindungsgemäßes Verfahren zur Überwachung des Betriebs einer elektrischen Anordnung in Form eines Flussdiagramms. Im Rahmen des Verfahrens zur Überwachung des Betriebs einer elektrischen Anordnung, welche eine Mehrzahl an in einer elektrischen Parallelschaltung angeordneten Spulen aufweist, wird in einem optionalen Schritt 11 der Betriebsstrom der Anordnung erfasst. In Schritt 12 wird an jeder Spule die anliegende Spannung mittels einer Anzapfung, die an einer Windung angeordnet ist, leistungsfrei erfasst, z.B. gemessen. Die Schritte 11 und 12 können auch in umgekehrter Reihenfolge oder gleichzeitig ausgeführt werden.

In Schritt 13 wird der in der jeweils gemessenen Spannung enthaltende AC-Anteil für jede Spule bestimmt, zum Beispiel erfasst. In Schritt 14 wird der Mittelwert der an den Spulen anliegenden Spannung bestimmt. In Schritt 15 wird der in der gemessenen Spannung enthaltende AC-Anteil für jede Spule in Bezug auf den bestimmten Mittelwert der Spannung ausgewertet, wobei eine Gewichtung, beispielsweise mittels des erfassten Betriebsstroms, vorgenommen wird. Dabei kann zum Beispiel der Effektivwert und/oder Amplitudenwert und/oder der Spitze-Spitze-Wert des für jede Spule ermittelten AC-Anteils durch den Betriebsstrom geteilt bzw. zu diesen ins Verhältnis gesetzt werden und auf diese Weise für die weitere Auswertung eine Gewichtung vorgenommen werden. Alternativ kann die Gewichtung mittels der Spannung vorgenommen werden.

Zusätzlich oder alternativ dazu kann für jede Spule das Differenzial, also die zeitliche Ableitung, des AC-Anteils der für die jeweilige Spule gemessenen Spannung mit dem erfassten Betriebsstrom gewichtet werden oder mit dem Differenzial des erfassten Betriebsstroms, also der zeitlichen Ableitung dessen, gewichtet werden. Dabei kann wiederum für den AC-Anteil der Effektivwert, der Amplitudenwert oder der Spitze-Spitze-Wert verwendet werden.

In Schritt 16 wird geprüft, ob die gewichtete Abweichung eines Wertes, der den in der gemessene Spannung enthaltenen AC-Anteil einer Spule beschreibt, also beispielsweise die in Schritt 15 ermittelten gewichteten Werte für beispielsweise Effektivwert, Amplitudenwert oder Spitze-Spitze-Wert, von einem Wert, der den Mittelwert der Spannung beschreibt, also beispielsweise der mittleren an den beteiligten Spulen anliegenden Spannung oder des Differenzials oder das Differenzial des Mittelwertes, einen festgelegten Grenzwert überschreitet. Ist dies der Fall, so wird in Schritt 17 ein Signal ausgegeben, vorzugsweise an eine Überwachungseinrichtung. Falls der Grenzwert nicht überschritten wird, springt das Verfahren zu Schritt 11 zurück.

Optional kann zusätzlich das Magnetfeld der einzelnen Spulen gemessen werden und das Verhältnis des Magnetfeldes zu dem Betriebsstrom und/oder dem AC-Anteil des Betriebsstroms ermittelt werden und falls das Verhältnis für eine Spule einen festgelegten Schwellenwert überschreitet, ein Signal ausgegeben werden.

Die Signalübertragung an eine Überwachungseinrichtung kann durch eine akustische Signalübertragung und/oder eine Signalübertragung mittels UV-Lichtwellen und/oder eine Signalübertragung mittels eines Lichtwellenleiters und/oder eine Signalübertragung mittels eines Funksignals erfolgen. Vorzugsweise erfolgt die Signalübertragung auf mindestens drei unterschiedlichen Wegen.

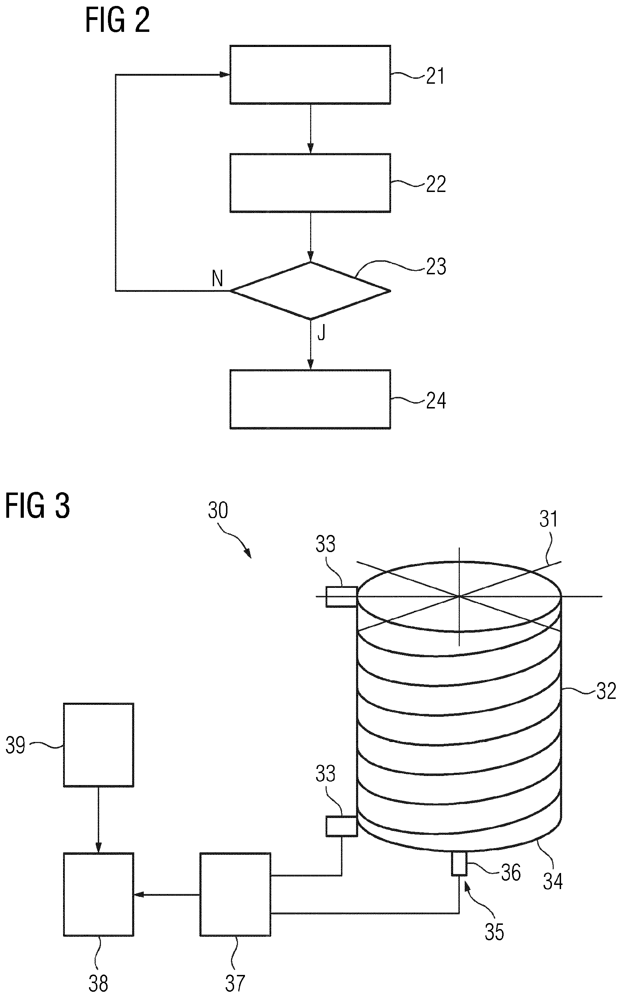

Die Figur 2 zeigt schematisch ein Verfahren zum Betreiben einer elektrischen Anordnung, welche eine Mehrzahl, beispielsweise mindestens 2 oder mindestens 3, elektrisch in einer Parallelschaltung angeordnete Spulen aufweist, in Form eines Flussdiagramms. In Schritt 21 wird die Anordnung bestimmungsgemäß betrieben. Dazu ist die Mehrzahl an Spulen von einem elektrischen Strom durchflossen. Beispielsweise kann an den Spulen eine Hochspannung anliegen. Bei der elektrischen Anordnung kann es sich zum Beispiel um eine Drossel oder einen Transformator handeln.

In Schritt 22 wird ein erfindungsgemäßes Verfahren, beispielsweise ein in der Figur 1 beschriebenes Verfahren, ausgeführt. Im Anschluss an die Ausgabe eines Signals im Rahmen dieses Verfahrens wird in Schritt 23 geprüft, ob eine festgelegte Anzahl an redundanten Signalen an einer Überwachungseinrichtung empfangen wurde. Ist dies nicht der Fall, so springt das Verfahren zu Schritt 21 zurück. Ist dies der Fall, wird der Betrieb der Anordnung in Schritt 24 unterbrochen und gegebenenfalls werden weitere Maßnahmen eingeleitet, zum Beispiel eine Abschaltung oder eine Wartung oder eine Reparatur. Bei der Anzahl an redundanten Signalen, welche die Überwachungseinrichtung für einen Übergang von Schritt 23 zu Schritt 24 empfangen haben muss, kann zum Beispiel das Empfangen von mindestens 2 aus 3 Signalen festgelegt sein.

Die Figur 3 zeigt schematisch eine erfindungsgemäße elektrische Anordnung 30 in einer teilweise perspektivischen Ansicht. Die Anordnung 30 umfasst eine Anzahl an elektrisch in einer Parallelschaltung angeordneten Spulen. Bei der Anordnung 30 kann es sich zum Beispiel um eine Drossel oder einen Transformator handeln. Die Anordnung 30 umfasst einen Tragstern 31. An dem Tragstern 31 ist eine Anzahl an Spulen 32 befestigt. In der Figur 3 ist lediglich eine Spule schematisch gezeigt. Die weiteren Spulen können konzentrisch innerhalb der gezeigten Spule 32 angeordnet sein. Jede der Spulen 32 umfasst ein Hauptanschluss-Terminal 33. An der ersten Windung 34 ausgehend von dem Hauptanschluss-Terminal 33 ist eine Anzapfung 35 angeordnet. An der ersten Windung 34 kann ein Anschluss-Terminal 36 angeordnet sein, welches dazu ausgelegt ist, mit einem Anzapfungskabel verbunden zu werden.

Die Anzapfung 35 und/oder das Anschluss-Terminal 36 sind nahe an dem Hauptanschluss-Terminal 33 angeordnet. Vorzugsweise ist die Anzapfung 35 bzw. das Anschluss-Terminal 36 in einem Abstand von weniger als einer halben Länge der ersten Windung 34, zum Beispiel in einem Abstand zwischen 20 cm und 50 cm, vorzugsweise in einem Abstand von ca. 30 cm, von dem Hauptanschluss-Terminal 33 entfernt angeordnet.

Das Hauptanschluss-Terminal 33 und die Anzapfung 35 sind mit einer Einrichtung 37 zum leistungsfreien Erfassen, beispielsweise Messen, der zwischen dem Hauptanschluss-Terminal 33 und der Abzweigung 35 anliegenden Spannung verbunden. Die Einrichtung zum leistungsfreien Erfassen der an der jeweiligen Spule anliegenden Spannung 37 ist mit einer Auswertungseinrichtung 38 zur Signalübertragung verbunden. Die Auswertungseinrichtung 38 kann optional darüber hinaus mit einer Einrichtung zum Erfassen des Betriebsstroms der Anordnung 39 zur Signalübertragung verbunden.

Die Auswertungseinrichtung 38 ist dazu ausgelegt, basierend auf empfangenen Signalen der Einrichtung zum leistungsfreien Erfassen der an den einzelnen Spulen anliegenden Spannung 37 und optional Signalen von der Einrichtung 39 zum Erfassen des Betriebsstroms gemäß einem oben beschriebenen, beispielsweise anhand der Figur 1 beschriebenen, Verfahren ein Signal zu generieren und auszugeben. Dabei kann die Auswertungseinrichtung 38 dazu ausgelegt sein, ein entsprechendes Signal auf mindestens 2, vorzugsweise mindestens 3, redundanten Signal-übertragungswegen an eine Überwachungseinrichtung zu übermitteln.

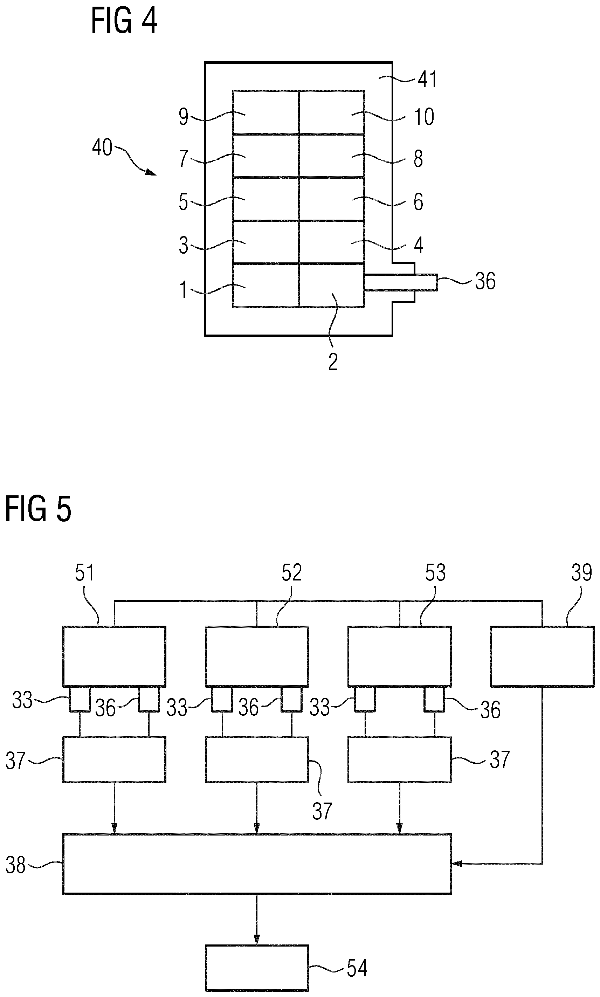

Die Figur 4 zeigt schematisch einen Querschnitt durch ein Leiterbündel 40 einer Spule 32. Dabei kann es sich um einen Querschnitt durch die erste Windung 34 handeln. Die Teilleiter des Teilleiterbündels 40 sind mit den Ziffern 1 bis 10 nummeriert, die Isolation des Leiterbündels 40 ist mit der Bezugsziffer 41 gekennzeichnet. Die Anzapfung 35 ist durch ein Anschluss-Terminal 36 in der gezeigten Ausgestaltung mit dem Teilleiter 2 durch die Isolierung 41 hindurch verbunden.

Ein solches Anschluss-Terminal 36 lässt sich auch bei bestehenden Spulen vergleichsweise einfach nachrüsten.

Die Figur 5 zeigt schematisch eine erfindungsgemäße Anordnung und das Prinzip der vorliegenden Erfindung in Form eines Blockdiagramms. Dabei sind beispielhaft drei Spulen einer erfindungsgemäßen Anordnung mit den Bezugsziffern 51,52 und 53 bezeichnet. Eine Vorrichtung zur Erfassung des an den Spulen anliegenden Gesamtstromes ist mit der Bezugsziffer 54 gekennzeichnet. Jede der Spulen 51,52 und 53 weist ein Hauptanschluss-Terminal 33 und eine Anzapfung, vorzugsweise mit einem Anschluss-Terminal 36 auf.

Jede der Spulen 51,52 und 53 ist mit einer Einrichtung 37 zur Erfassung der zwischen dem jeweiligen Hauptanschluss-Terminal 33 und der Abzweigung 35 anliegenden Spannung verbunden. Jede der Einrichtungen 37 ist zur Signalübertragung, gekennzeichnet durch Pfeile, mit der Auswertungseinrichtung 38 verbunden. Die Auswertungseinrichtung 38, welche optional auch dazu ausgelegt ist von der Einrichtung zur Erfassung des Gesamtstroms 39 Signale zu empfangen, ist dazu ausgelegt, gemäß dem oben beschriebenen erfindungsgemäßen Verfahren ein Signal zu generieren und auszugeben. Die Ausgabe des Signals kann optional an eine Überwachungseinrichtung 54 erfolgen.

### Bezugszeichenliste

- 1-10: Teilleiter
- 11: Erfassen des Betriebsstroms der Anordnung
- 12: leistungsfreies Erfassen der an jeder Spule anliegenden Spannung
- 13: Bestimmen des in der jeweils gemessenen Spannung enthaltenden AC-Anteils für jede Spule
- 14: Bestimmen des Mittelwertes der an den Spulen anliegenden Spannung
- 15: Auswerten des AC-Anteils für jede Spule in Bezug auf den bestimmten Mittelwert der Spannung
- 16: Überschreitet die gewichtete Abweichung eines Wertes, der den in der gemessenen Spannung enthaltenen AC-Anteil einer Spule beschreibt, von einem Wert, der den Mittelwert der Spannung beschreibt, einen festgelegten Grenzwert?
- 17: Signalausgabe
- 21: Betreiben der Anordnung
- 22: Verfahren zur Überwachung ausführen
- 23: Prüfen, ob eine festgelegte Anzahl an redundanten Signalen an einer Überwachungseinrichtung empfangen wurde
- 24: Unterbrechung des Betriebs
- 30: elektrische Anordnung
- 31: Tragstern
- 32: Spulen
- 33: Hauptanschluss-Terminal
- 34: erste Windung
- 35: Anzapfung
- 36: Anschluss-Terminal
- 37: Einrichtung zum leistungsfreien Erfassen der an der jeweiligen Spule anliegenden Spannung
- 38: Auswertungseinrichtung
- 39: Einrichtung zum Erfassen des Betriebsstroms
- 40: Leiterbündel
- 41: Isolierung
- 51: Spule
- 52: Spule
- 53: Spule
- 54: Überwachungseinrichtung
- J: ja
- N: nein

## Patentansprüche

1. Verfahren zur Überwachung des Betriebs einer elektrischen Anordnung (30), welche eine Mehrzahl an elektrisch in einer Parallelschaltung angeordneten Spulen (32, 51, 52, 53) aufweist,
**dadurch gekennzeichnet, dass**
das Verfahren folgende Schritte umfasst:
- leistungsfreies Erfassen der an jeder Spule anliegenden Spannung mittels einer Anzapfung an einer Windung (12),
- Bestimmen des in der jeweils erfassten Spannung enthaltenen AC-Anteils für jede Spule (13),
- Bestimmen des Mittelwertes der an den Spulen anliegenden Spannung (14),
- Auswerten des bestimmten AC-Anteils für jede Spule in Bezug auf den bestimmten Mittelwert der Spannung, wobei eine Gewichtung vorgenommen wird (15),
- Ausgeben eines Signals (17), falls eine gewichtete Abweichung eines Wertes, der den in der erfassten Spannung enthaltenen AC-Anteil einer Spule beschreibt, von einem Wert, der den Mittelwert der Spannung beschreibt, einen festgelegten Grenzwert überschreitet (16).

2. Verfahren nach Anspruch 1,
**dadurch gekennzeichnet, dass**
jede der Spulen (32, 51, 52, 53) einen Hauptanschluss-Terminal (33) aufweist und das leistungsfreie Erfassen der an jeder Spule anliegenden Spannung zwischen dem Hauptanschluss-Terminal (33) und der Anzapfung (35) erfolgt,
wobei die Anzapfung (35) an einer ersten Windung (34) ausgehend von dem Hauptanschluss-Terminal (33) angeordnet ist.

3. Verfahren nach Anspruch 2,
**dadurch gekennzeichnet, dass**
die Anzapfung (35) in einem Abstand von maximal zwei Dritteln der Leiterlänge der ersten Windung (34) ausgehend von dem Hauptanschluss-Terminal (33) angeordnet ist.

4. Verfahren nach einem der Ansprüche 1 bis 3,
**dadurch gekennzeichnet, dass**
der Betriebsstroms der Anordnung (11) erfasst und zur Gewichtung verwendet wird und/oder die Gewichtung in Bezug auf den Absolutwert der aktuell am Abgriff gemessenen Spannung oder in Bezug auf den Mittelwert der an den Abgriffen gemessenen Spannungen vorgenommen wird.

5. Verfahren nach einem der Ansprüche 1 bis 4,
**dadurch gekennzeichnet, dass**
als Wert, der den in der erfassten Spannung enthaltenen AC-Anteil einer Spule beschreibt, der Effektivwert und/oder der Amplitudenwert und/oder der Spitze-Spitze-Wert des AC-Anteils und/oder die zeitliche Änderung der Abweichung der erfassten Spannung von dem Mittelwert ermittelt wird und/oder als ein Wert, der den Mittelwert der Spannung beschreibt, der Mittelwert des DC-Anteils der Spannung und/oder der Mittelwert der Effektivwerte der AC-Anteile der Spannung der einzelnen Spulen und/oder der Mittelwert der Amplitudenwerte und/oder der Mittelwert der Spitze-Spitze-Werte und/oder die zeitliche Änderung des Mittelwertes der Spannung ermittelt wird.

6. Verfahren nach einem der Ansprüche 1 bis 5,
**dadurch gekennzeichnet, dass**
der AC-Anteil des Betriebsstroms erfasst wird und zur Gewichtung verwendet wird und/oder das Verhältnis der Abweichung des Wertes, der den in der erfassten Spannung enthaltenen AC-Anteil einer Spule beschreibt, von dem Wert, der den Mittelwert der Spannung beschreibt, zu dem AC-Anteil des Betriebsstroms ermittelt wird und falls das Verhältnis einen festgelegten Grenzwert überschreitet, ein Signal ausgegeben wird.

7. Verfahren nach einem der Ansprüche 1 bis 6,
**dadurch gekennzeichnet, dass**
das Magnetfeld der einzelnen Spulen gemessen wird und das Verhältnis des Magnetfeldes zu dem Betriebsstrom und/oder dem AC-Anteil des Betriebsstroms ermittelt wird und falls das Verhältnis für eine Spule einen festgelegten Schwellenwert erreicht, ein Signal ausgegeben wird.

8. Verfahren nach einem der Ansprüche 1 bis 7,
**dadurch gekennzeichnet, dass**
das den AC-Anteil der erfassten Spannung beschreibende Signal und/oder ein den AC-Anteil des erfassten Betriebsstroms beschreibendes Signal gleichgerichtet wird und/oder geglättet wird.

9. Verfahren nach einem der Ansprüche 1 bis 8,
**dadurch gekennzeichnet, dass**
mindestens ein Signal über eine Mehrzahl redundanter Signalübertragungswege an eine Überwachungseinrichtung (54) übertragen wird.

10. Verfahren nach einem der Ansprüche 1 bis 9,
**dadurch gekennzeichnet, dass**
mittels einer Induktionsspule aus einem Wechselfeld der Spulen Energie gewonnen und zur Auswertung und/oder zur Generierung von Signalen und/oder zur Übertragung von Signalen verwendet wird.

11. Elektrische Anordnung (30), welche eine Mehrzahl an elektrisch in einer Parallelschaltung angeordneten Spulen (32, 51, 52, 53) aufweist,
**dadurch gekennzeichnet, dass**
jede Spule (32, 51, 52, 53) eine Anzapfung (35) einer Windung (34) aufweist, die Anordnung (30) eine Einrichtung zum leistungsfreien Erfassen der an jeder Spule anliegenden Spannung (37) mittels der Anzapfung (35) und eine Auswertungseinrichtung (38) umfasst, und
die Anordnung (30) zur Ausführung eines Verfahrens gemäß einem der Ansprüche 1 bis 10 ausgelegt ist.

12. Anordnung (30) nach Anspruch 11,
**dadurch gekennzeichnet, dass**
die Anordnung (30) mindestens eine Induktionsspule zur Energiegewinnung umfasst.

13. Anordnung (30) nach Anspruch 11 oder 12,
**dadurch gekennzeichnet, dass**
jede der Spulen (32, 51, 52, 53) einen Hauptanschluss-Terminal (33) aufweist, die Anzapfung (35) an einer ersten Windung (34) ausgehend von dem Hauptanschluss-Terminal (33) angeordnet ist und die Einrichtung (37) zum leistungsfreien Erfassen der an jeder Spule anliegenden Spannung zum Erfassen der Spannung zwischen dem Hauptanschluss-Terminal (33) und der Anzapfung (35) ausgelegt ist.

14. Anordnung (30) nach Anspruch 13, **dadurch gekennzeichnet, dass**
die Anzapfung (35) in einem Abstand von maximal zwei Dritteln der Leiterlänge der ersten Windung (34) ausgehend von dem Hauptanschluss-Terminal (33) angeordnet ist.

15. Anordnung (30) nach einem der Ansprüche 11 bis 14, **dadurch gekennzeichnet, dass**
die Anordnung (30) einen Tragstern (31) umfasst, an welchem die Spulen (32, 51, 52, 53) befestigt sind, und die Anzapfungen (35) so ausgestaltet sind, dass sie aus den Spulen (32, 51, 52, 53) in Richtung des Tragsterns (31) geführt sind.

16. Anordnung (30) nach einem der Ansprüche 11 bis 15, **dadurch gekennzeichnet, dass**
die Anordnung (30) eine Signal-Bedämpfungs-Drossel und/oder einen Überspannungsableiter aufweist.

17. Verfahren zum Betreiben einer Anordnung (30) gemäß einem der Ansprüche 11 bis 16,
**dadurch gekennzeichnet, dass**
die Anordnung betrieben wird (21), wobei ein Verfahren zur Überwachung des Betriebs der Anordnung gemäß einem der Ansprüche 1 bis 10 durchgeführt wird (22), und der Betrieb der Anordnung unterbrochen wird (24), falls im Rahmen des Verfahrens zur Überwachung mindestens ein Signal an eine Überwachungseinrichtung ausgegeben wird, welches auf mindestens zwei redundanten Übertragungswegen von einer Überwachungseinrichtung empfangen wurde (23).

## Claims

1. A method for monitoring the operation of an electrical arrangement (30) which has a plurality of coils (32, 51, 52, 53) electrically arranged in a parallel connection,
**characterised in that**
the method comprises the following steps:
- detecting, in a powerless manner, the voltage applied to each coil by means of a tap on a winding (12),
- determining the AC portion contained in the respectively detected voltage for each coil (13),
- determining the mean value of the voltage applied to the coils (14),
- evaluating the determined AC portion for each coil with regard to the determined mean value of the voltage, wherein a weighting is made (15),
- outputting a signal (17) if a weighted deviation of a value which describes the AC portion of a coil contained in the detected voltage from a value which describes the mean value of the voltage exceeds a defined limit value (16).

2. The method according to claim 1,
**characterised in that**
each of the coils (32, 51, 52, 53) has a main connection terminal (33) and detecting, in a powerless manner, the voltage applied to each coil is between the main connection terminal (33) and the tap (35),
wherein the tap (35) is arranged on a first winding (34) starting from the main connection terminal (33).

3. The method according to claim 2,
**characterised in that**
the tap (35) is arranged at a distance of at most two thirds of the conductor length of the first winding (34) starting from the main connection terminal (33).

4. The method according to any one of claims 1 to 3, **characterised in that**
the operating current of the arrangement (11) is detected and used for weighting and/or the weighting is made with regard to the absolute value of the voltage currently measured at the tap or with regard to the mean value of the voltages measured at the taps.

5. The method according to any one of claims 1 to 4, **characterised in that**
the effective value and/or the amplitude value and/or the peak-to-peak value of the AC portion and/or the change over time of the deviation of the detected voltage from the mean value is determined as a value which describes the AC portion of a coil contained in the detected voltage, and/or the mean value of the DC portion of the voltage and/or the mean value of the effective values of the AC portions of the voltage of the individual coils and/or the mean value of the amplitude values and/or the mean value of the peak-to-peak values and/or the change over time of the mean value of the voltage is determined as a value which describes the mean value of the voltage.

6. The method according to any one of claims 1 to 5, **characterised in that**
the AC portion of the operating current is detected and used for weighting and/or the ratio of the deviation of the value which describes the AC portion of a coil contained in the detected voltage from the value which describes the mean value of the voltage to the AC portion of the operating current is determined and if the ratio exceeds a defined limit value, a signal is output.

7. The method according to any one of claims 1 to 6, **characterised in that**
the magnetic field of the individual coils is measured and the ratio of the magnetic field to the operating current and/or the AC portion of the operating current is determined and if the ratio for a coil reaches a defined threshold value, a signal is output.

8. The method according to any one of claims 1 to 7, **characterised in that**
the signal which describes the AC portion of the detected voltage and/or a signal which describes the AC portion of the detected operating current is rectified and/or smoothed.

9. The method according to any one of claims 1 to 8, **characterised in that**
at least one signal is transmitted to a monitoring device (54) via a plurality of redundant signal transmission paths.

10. The method according to any one of claims 1 to 9, **characterised in that**
energy is recovered by means of an induction coil from an alternating field of the coils and used for evaluating and/or generating signals and/or for transmitting signals.

11. An electric arrangement (30), which has a plurality of coils (32, 51, 52, 53) electrically arranged in a parallel connection, **characterised in that**
each coil (32, 51, 52, 53) has a tap (35) of a winding (34), the arrangement (30) comprises a device for detecting, in a powerless manner, the voltage (37) applied to each coil by means of the tap (35) and an evaluation device (38), and
the arrangement (30) is designed for executing a method according to any one of claims 1 to 10.

12. The arrangement (30) according to claim 11,
**characterised in that**
the arrangement (30) comprises at least one induction coil for energy recovery.

13. The arrangement (30) according to claim 11 or 12, **characterised in that**
each of the coils (32, 51, 52, 53) has a main connection terminal (33), the tap (35) is arranged on a first winding (34) starting from the main connection terminal (33) and the device (37) for detecting, in a powerless manner, the voltage applied to each coil is designed for detecting the voltage between the main connection terminal (33) and the tap (35).

14. The arrangement (30) according to claim 13,
**characterised in that**
the tap (35) is arranged at a distance of at most two thirds of the conductor length of the first winding (34) starting from the main connection terminal (33).

15. The arrangement (30) according to any one of claims 11 to 14,
**characterised in that**
the arrangement (30) comprises a support star (31) to which the coils (32, 51, 52, 53) are fastened, and the taps (35) are configured to be guided out of the coils (32, 51, 52, 53) in the direction of the support star (31).

16. The arrangement (30) according to any one of claims 11 to 15,
**characterised in that**
the arrangement (30) has a signal vaporisation throttle and/or a surge protector.

17. A method for operating an arrangement (30) according to any one of claims 11 to 16,
**characterised in that**
the arrangement is operated (21), wherein a method for monitoring the operation of the arrangement according to any one of claims 1 to 10 is performed (22), and the operation of the arrangement is interrupted (24) if, within the context of the method for monitoring, at least one signal which was received (23) by a monitoring device on at least two redundant transmission paths is output to a monitoring device.

## Revendications

1. Procédé de surveillance du fonctionnement d'un agencement électrique (30) comportant une pluralité de bobines (32, 51, 52, 53) disposées électriquement en parallèle,
**caractérisé en ce que**
la procédure comprend les étapes suivantes :
- la détection sans alimentation de la tension appliquée à chaque bobine au moyen d'une prise sur un enroulement (12),
- la détermination de la composante alternative contenue dans la tension détectée respective pour chaque bobine (13),
- la détermination de la valeur moyenne de la tension appliquée aux bobines (14),
- l'évaluation de la composante alternative déterminée pour chaque bobine par rapport à la valeur moyenne déterminée de la tension, une pondération étant effectuée (15),
- l'émission d'un signal (17) si un écart pondéré d'une valeur décrivant la composante alternative d'une bobine contenue dans la tension détectée par rapport à une valeur décrivant la valeur moyenne de la tension dépasse une valeur limite spécifiée (16).

2. Procédé selon la revendication 1,
**caractérisé en ce que**
chacune des bobines (32, 51, 52, 53) possède une borne de connexion principale (33) et la détection hors tension de la tension appliquée à chaque bobine s'effectue entre la borne de connexion principale (33) et la prise (35),
dans lequel la prise (35) est disposée sur un premier enroulement (34) à partir de la borne de connexion principale (33).

3. Procédé selon la revendication 2,
**caractérisé en ce que**
la prise (35) est disposée à une distance d'un maximum de deux tiers de la longueur du conducteur du premier enroulement (34) de la borne de connexion principale (33).

4. Procédé selon l'une quelconque des revendications 1 à 3, **caractérisé en ce que**
le courant de fonctionnement de l'agencement (11) est détecté et utilisé pour la pondération et/ou la pondération est effectuée par rapport à la valeur absolue de la tension actuellement mesurée à la prise ou par rapport à la valeur moyenne des tensions mesurées aux prises.

5. Procédé selon l'une quelconque des revendications 1 à 4, **caractérisé en ce que**
en tant que valeur décrivant la composante alternative d'une bobine contenue dans la tension enregistrée, la valeur efficace et/ou la valeur d'amplitude et/ou la valeur crête à crête de la composante alternative et/ou la variation temporelle de l'écart de la tension enregistrée par rapport à la valeur moyenne sont déterminées et/ou en tant que valeur décrivant la valeur moyenne de la tension, la valeur moyenne de la composante continue de la tension et/ou la valeur moyenne des valeurs efficaces des composantes alternatives de la tension des bobines individuelles et/ou la valeur moyenne des valeurs d'amplitude et/ou la valeur moyenne des valeurs crête à crête et/ou la variation temporelle de la valeur moyenne de la tension sont déterminées.

6. Procédé selon l'une quelconque des revendications 1 à 5, **caractérisé en ce que**
la composante alternative du courant de fonctionnement est enregistrée et utilisée pour la pondération et/ou le rapport de l'écart de la valeur décrivant la composante alternative d'une bobine contenue dans la tension enregistrée à partir de la valeur décrivant la valeur moyenne de la tension à la composante alternative du courant de fonctionnement est déterminé et si le rapport dépasse une limite spécifiée, un signal est émis.

7. Procédé selon l'une quelconque des revendications 1 à 6, **caractérisé en ce que**
le champ magnétique de chaque bobine est mesuré et le rapport du champ magnétique par rapport au courant de fonctionnement et/ou par rapport à la composante alternative du courant de fonctionnement est déterminé et si le rapport pour une bobine atteint une valeur seuil spécifiée, un signal est émis.

8. Procédé selon l'une quelconque des revendications 1 à 7, **caractérisé en ce que**
le signal décrivant la composante alternative de la tension détectée et/ou un signal décrivant la composante alternative du courant de fonctionnement détecté est redressé et/ou lissé.

9. Procédé selon l'une quelconque des revendications 1 à 8, **caractérisé en ce que**
au moins un signal est transmis à un dispositif de surveillance (54) via une pluralité de chemins de transmission de signal redondants.

10. Procédé selon l'une des revendications 1 à 9,
**caractérisé en ce que**
l'énergie est obtenue à partir d'un champ alternatif des bobines au moyen d'une bobine d'induction et est utilisée pour l'évaluation et/ou pour la génération de signaux et/ou pour la transmission de signaux.

11. Agencement électrique (30) comprenant une pluralité de bobines (32, 51, 52, 53) disposées électriquement en parallèle,
**caractérisé en ce que**
chaque bobine (32, 51, 52, 53) possède une prise (35) d'un enroulement (34), l'agencement (30) comprend un dispositif de détection hors tension de la tension (37) appliquée à chaque bobine au moyen de la prise (35) et un dispositif d'évaluation (38), et
l'agencement (30) est conçu pour mettre en œuvre un procédé selon l'une quelconque des revendications 1 à 10.

12. Agencement (30) selon la revendication 11,
**caractérisé en ce que**
l'agencement (30) comprend au moins une bobine d'induction pour la génération d'énergie.

13. Agencement (30) selon la revendication 11 ou 12, **caractérisé en ce que**
chacune des bobines (32, 51, 52, 53) comporte une borne de connexion principale (33), la prise (35) est disposée sur un premier enroulement (34) à partir de la borne de connexion principale (33), et le dispositif (37) de détection hors tension de la tension appliquée à chaque bobine est conçu pour détecter la tension entre la borne de connexion principale (33) et la prise (35).

14. Agencement (30) selon la revendication 13,
**caractérisé en ce que**
la prise (35) est disposée à une distance d'un maximum de deux tiers de la longueur du conducteur du premier enroulement (34) de la borne de connexion principale (33).

15. Agencement (30) selon l'une quelconque des revendications 11 à 14,
**caractérisé en ce que**
l'agencement (30) comprend un corps de palier (31) sur lequel sont fixées les bobines (32, 51, 52, 53), et les prises (35) sont conçues de telle sorte qu'elles sont guidées depuis les bobines (32, 51, 52, 53) en direction du corps de palier (31).

16. Agencement (30) selon l'une quelconque des revendications 11 à 15,
**caractérisé en ce que**
l'agencement (30) comprend une self d'amortissement de signal et/ou un parafoudre.

17. Procédé de fonctionnement d'un agencement (30) selon l'une quelconque des revendications 11 à 16,
**caractérisé en ce que**
l'agencement est mis en fonctionnement (21), un procédé de surveillance du fonctionnement de l'agencement selon l'une quelconque des revendications 1 à 10 étant mis en œuvre (22), et le fonctionnement de l'agencement étant interrompu (24) si, dans le cadre du procédé de surveillance, au moins un signal est émis vers un dispositif de surveillance qui a été reçu par un dispositif de surveillance sur au moins deux chemin de transmission redondants (23).
